# EUROPEAN PATENT APPLICATION

(11) **EP 0 610 564 A2**
(43) Date of publication of application: **17.08.1994**
(21) Application number: 93119217.3
(22) Date of filing: 29.11.1993
(51) Int. Cl.: H01L 29/812, H01L 29/60, H03D 7/12, H01L 29/784, H03F 1/22

(54) **Dual gate fet and circuits using dual gate fet**

(30) Priority: 26.01.1993 JP 10780/93
(71) Applicant: Sumitomo Electric Industries, Ltd., Osaka 541 (JP)
(72) Inventor: Shiga, Nobuo, c/o Yokohama Works of Sumitomo, Yokohama-shi, Kanagawa (JP)
(74) Representative: Grünecker, Kinkeldey, Stockmair & Schwanhäusser Anwaltssozietät

(57) **Abstract**

A dual gate FET structure allowing the FET to achieve a high gain, and circuits utilizing the dual gate FET including a variable gain amplifier and a mixer. The gate width of the first (source side) gate electrode is different from the width of a second (drain side) electrode. When the dual gate FET is used in a variable gain amplifier, high gain can be obtained when the drain-side gate is made narrower than the source-side gate. With the gate widths of the first and second gate electrodes reversed (source-side gate narrower) the FET is particularly well suited for use in a mixer circuit.

## Description

### BACKGROUND OF THE INVENTION

The present invention relates to a field effect transistor (FET) having two gate electrodes between its source and drain thereof, that is, a dual gate field effect transistor (dual gate FET). The invention is also directed to an amplifier circuit and a mixer circuit respectively using different embodiments of the dual gate field effect transistor.

With the recent rapid development of information network systems, the demand for a satellite communications has also increased rapidly. There is a concurrent greater demand for the use of higher frequency bands. FETs, especially, MES-FETs formed of GaAs have proven to be particularly useful in this regard. Their characteristics surpass those of traditional silicone bipolar transistors.

FETs have proven to be particularly useful in variable gain amplifier circuits. The gain of the amplifier is a function of a voltage signal applied to a gate of the FET. Dual gate FETs are particularly useful in mixer circuits used for frequency conversion.

It is known that the gain of an amplifier is proportional to a ratio, gm/gd, of its transmission conductance gm to its output conductance gd thereof. In general, the output conductance gd of a dual gate FET is smaller than that of a single gate FET. The gain of a dual gate FET amplifier can be made larger than of an amplifier using a single gate FET. Also, it is convenient to be able to apply an input signal to the first gate of a dual gate FET and a control voltage to the second gate that allows one to change the gain of the amplifier.

Dual gate FETs are also convenient for use in a mixer circuit, such as, for example, a down- converter. A high frequency input signal can be input to one of the gates and a local oscillator signal can be input to the other gate. The two signals are mixed without need for extra circuitry for isolating the two inputs.

Although dual gate FETs are effectively utilized as amplifiers and mixers, there are some problems still to be overcome.

The use of a dual gate FET in a mixer requires the use of complicated biasing circuitry. The drain-source voltage associated with the first gate is narrower than the drain-source voltage associated with the second gate. The only way to get the FET to operate with a linear characteristic is to zero bias both the first and second gates. However, at zero bias, it is not possible to obtain sufficient gain. To cause the FET to be driven to saturation using only a single power source requires the use of a complicated bias circuit.

An amplifier using a dual gate FET can obtain a higher gain than an amplifier using a signal gate FET. Even with the higher gain afforded by the dual gate FET, it is still insufficient gain for various applications.

### SUMMARY OF THE INVENTION

In view of the above, the present invention provides a dual gate FET and circuits incorporating a dual gate FET that operate in a superior fashion to known devices and circuits.

The present invention provides a dual gate FET in which the gate width of a first gate electrode (source-side gate electrode) and the gate width of a second gate electrode (drain-side gate electrode) are different from each other. In one embodiment the source-side gate is wider than the drain-side gate. In another embodiment the source-side gate is narrower than the drain-side gate.

The present invention also provides an amplifier using a dual gate FET according to the present invention. For use in an amplifier, the gate width of the second electrode (drain- side) is narrower than the gate width of the first electrode (source-side). The first gate electrode is used as a signal input terminal, the second gate electrode is used as a gain control terminal, and the drain electrode is used as a signal output terminal.

According to the invention, there is further provided a mixer circuit using the dual gate FET of the invention. For use in a mixer circuit, the gate width of the first gate electrode (source-side) is narrower than the gate width of the second gate electrode (drain-side). The first gate electrode is used as a signal input terminal, the second gate electrode is used as a local oscillation signal input terminal, and the drain is used as a signal output terminal.

The gain of a FET is proportional to gm/gd. Although gm and gd are both proportional to the gate width, if only the gate width of the second gate electrode (drain-side) is shortened, then only gd can be reduced. For this reason, when compared with a dual gate FET in which the gate widths of the first and second gate electrodes are the same, gm/gd is greater and thus, if such FET is used in an amplifier, then a high gain can be obtained.

Also, by making the gate width of the first gate electrode narrower than that of the second gate electrode, the drain-source voltage in the first gate electrode can be made greater. This allows the first gate side of the amplifier to operate in a saturation region without adding a complicated bias circuit thereto. Therefore, if such dual gate FET is used in a mixer circuit, then a high gain can be obtained.

### BRIEF DESCRIPTION OF THE DRAWINGS

Figure 1 is a schematic diagram of an amplifier circuit according to the invention;
Figure 2 is a perspective view of the structure of a dual gate FET 1 according to the invention and as used in the amplifier circuit shown in Figure 1;
Figure 3 is a schematic diagram of a mixer circuit (down converter) according to the invention;
Fig. 4 is a perspective view of the structure of a dual gate FET 31 according to the present invention and as used in the mixer circuit shown in Fig. 3; and
Fig. 5 is a graphical representation of an ld-Vd characteristic of the dual gate FET 31 used in the mixer circuit shown in Fig. 3.

### DETAILED DESCRIPTION OF THE PREFERRED EMBODIMENTS

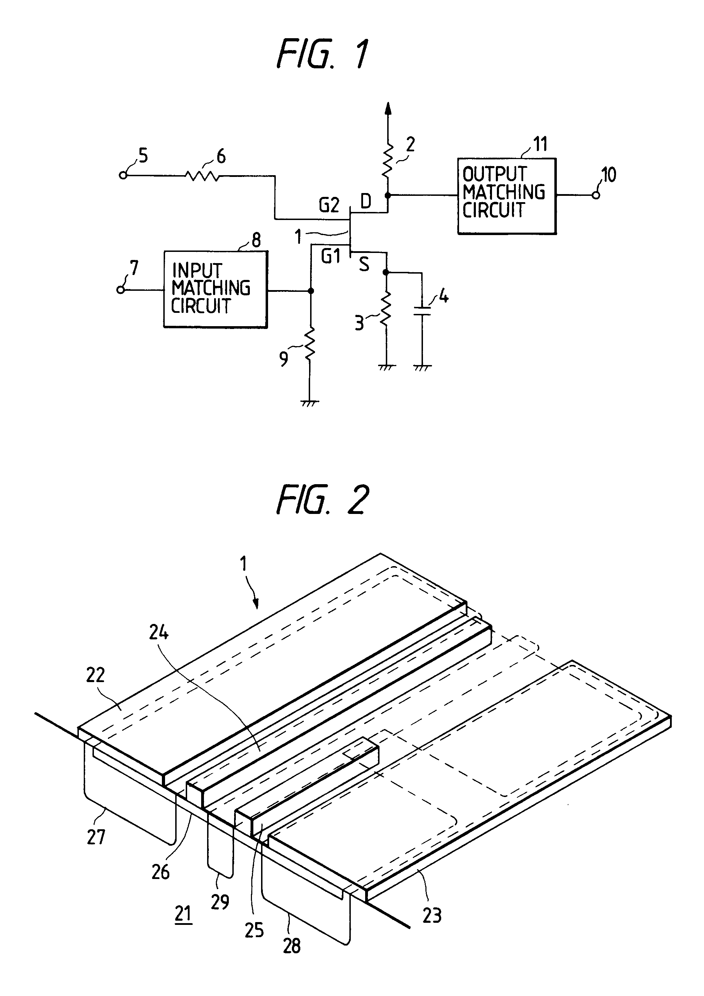

Fig. 1 is a schematic circuit diagram of an amplifier circuit according to the invention. A dual gate FET 1 has a drain D which is connected through an output matching circuit 11 to an output terminal 10. A power source provides power to drain D via a drain resistor 2. The source S of the dual gate FET 1 is grounded through a self biasing resistor 3. A bypass capacitor 4 is connected in parallel to resistor 3. A signal input terminal 7 is connected through an input matching circuit 8 to a first gate electrode G1 (source-side) gate electrode of the dual gate FET 1. A gate biasing resistor 9 is coupled between ground and a node coupled to both matching circuit 8 and gate G1. A gain control terminal 5 is connected through a protective resistor 6 to a second gate electrode G2 which is a drain-side gate electrode. The width of the second gate electrode G2 is narrower than that of the first gate electrode G1.

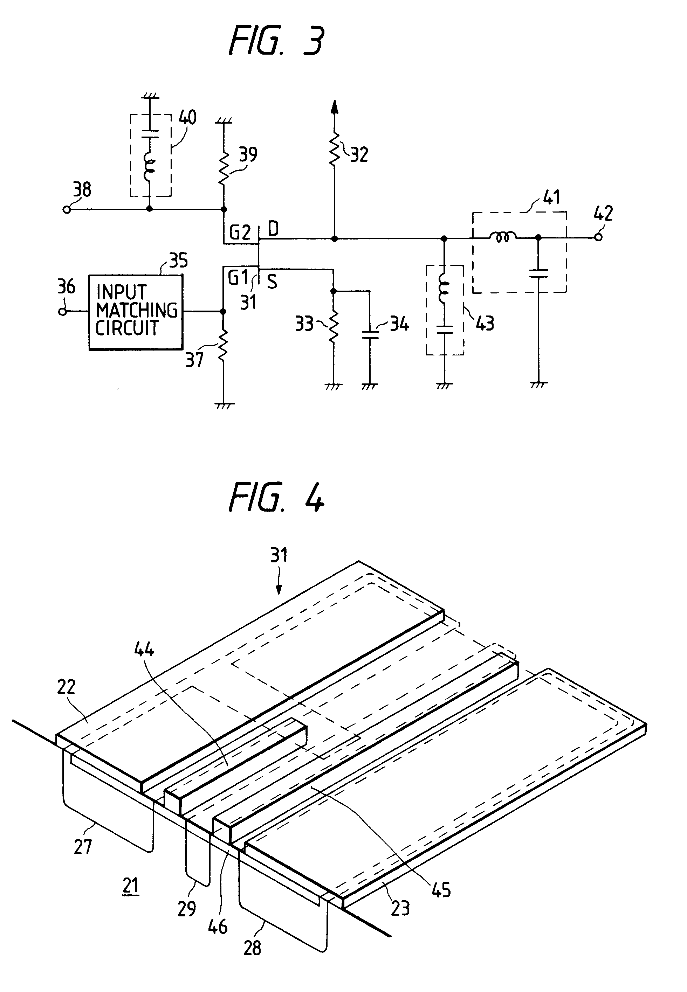

Fig. 2 is a perspective view of the structure of the dual gate FET 1. The dual gate FET 1 is a Schottky gate type FET which is formed on a GaAs semiconductor substrate 21. On the surface of substrate 21 there is formed an activated layer 26 and n⁺ high density impurity areas 27, 28, 29 which are respectively formed by ion injection. A source electrode 22 is formed on the source impurity area 27 in a manner so as to form an ohmic contact. A drain electrode 23 is formed on the drain impurity area 28 also in a manner so as to form an ohmic contact. On the activated layer 26, between the source and drain electrodes, there are formed first and second gate electrodes 24 and 25, respectively, in a Schottky connection manner. Gate electrode 25, on the drain side, has a gate width that is narrower than that of the first gate electrode 24 on the source side.

The thus structured dual gate FET 1 is equivalent to a circuit which would include a first FET having a gate electrode 24, source electrode 22 and drain electrode 23, and a second FET having a gate electrode 25 and source electrode 22 and drain electrode 23, the first and second FETs being connected in series with each other.

The amplifier amplifies a signal input to signal input terminal 7. It provides an amplified output signal to output terminal 10. Gain control is applied to terminal 5. Because the width of the second gate electrode 25 is narrower than that of the first gate electrode 24 (unlike conventional dual gate FETs which have the same gate width), the value of gm/gd is greater and thus a higher gain can be obtained. By leaving the gate width of the first gate electrode as it would be in a conventional FET and reducing only the gate width of the second gate electrode, the drain conductance gd can be reduced without changing the value of the transmission conductance gm.

Fig. 3 is a circuit diagram of a mixer circuit according to the invention. A dual gate FET 31 has a drain D which is connected through a low-pass filter 41 to an intermediate frequency (IF) signal terminal 42. Drain D is also connected through a drain resistor 32 to a power source. Between the drain and low-pass filter 41, there is a connection to a local oscillator trap circuit 43, one terminal of which is grounded. The local oscillator trap circuit 43 is an LC series resonance circuit which prevents the local oscillator signal from leaking to the output.

The source S of FET 31 is grounded through a self bias resistor 33. A bypass capacitor 34 is connected in parallel to resistor 33. A high frequency (RF) signal input terminal 36 is connected through an input matching circuit 35 to the first gate electrode G1 of FET 31. Between the input matching circuit 35 and first gate electrode, there is connected the other terminal of a gate bias resistor 37 one terminal of which is grounded. A local oscillator signal input terminal 38 is connected to the second gate electrode G2 of the dual gate FET 31 and, between them, there are connected the other terminal of a gate bias resistance 39 with one terminal thereof grounded and the other terminal of an IF trap circuit 40 with one terminal thereof grounded. The IF trap circuit 40 is an LC series resonance circuit, that is, a circuit which is used to prevent a mixed-down IF signal to be output to the output side from being leaked to the local oscillation signal input terminal 38.

Fig. 4 is a perspective view of the structure of a dual gate FET 31 according to the present invention and as used in the mixer circuit shown in Fig. 3. The gate width of the second gate electrode (drain-side) 45 is wider than the gate width of the first gate electrode (source-side) 44. In this structure, a source-drain voltage on the first gate electrode side can be made large. Thus, the first gate electrode side can operate in a saturation region (as does the second electrode side). The components other than the first gate electrode 44, second gate electrode 45 and activated layer 46, not specifically described, are respectively the same as or analogous to those having the same reference numerals in Figure 2.

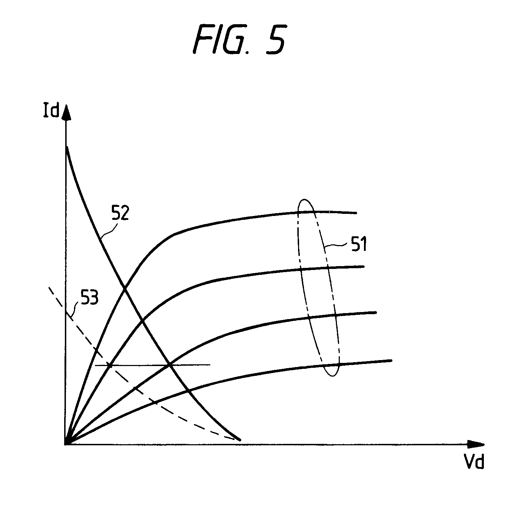

Figure 5 is a graphical representation of operating characteristics which explains the operation of dual gate FETs according to the invention. Drain current (Id) is plotted along the vertical axis and drain voltage (Vd) is plotted along the horizontal axis. The graph shows the ld - Vd characteristic of a first FET, which is includes first gate electrode 44, a source electrode 22 and a drain electrodes 23. It also shows the drain current (Id) - gate voltage (Vg) characteristic of a second FET which includes the second gate electrode 45, a source electrode 22 and a drain electrode 23. Due to the fact that the current-voltage characteristic of the second embodiment rises faster compared with a drain current (Id) - drain voltage (Vg) characteristic 53 obtained when the gate width of the second gate electrode 45 is equal to the gate width of the first gate electrode 44, the first FET composed of the first gate electrode 44, source electrode 22 and drain electrode 23 can operate in a saturation region so that a high gain can be obtained.

The dual gate FET of the invention can provide a high gain when it is used in an amplifier or in a mixer circuit, because the two gate electrodes of the dual gate FET have different widths. The amplifier circuit of the invention provides a high gain because the value of gm/gd of the non-equal gate width dual FET is greater than that of a conventional dual gate FET. In the mixer circuit according to the invention, the first FET, including the first gate electrode and source-drain electrodes and to which a signal can be input without adding a complicated bias circuit, is allowed to operate in a saturation area, so that a high gain can be obtained.

## Claims

1. A dual gate field effect transistor, comprising:
a source;
a drain;
a first gate electrode;
a second gate electrode having a width that is different from that of first gate electrode.

2. A dual gate FET according to claim 1 wherein the first gate is narrower than the second gate.

3. A dual gate FET according to claim 1 wherein the second gate is narrower than the first gate.

4. A variable gain amplifier circuit comprising:
a dual gate field effect transistor having a source, a drain, a first (source side) gate electrode and a second (drain side) gate electrode, the gate width of the second gate electrode being narrower than that of the first gate electrode;
means for coupling an input signal to the first gate electrode;
means for coupling a gain control signal to the second gate; and
means for receiving an output signal of the amplifier circuit from the drain.

5. A mixer circuit comprising:
a dual gate field effect transistor having a source, a drain, a first (source side) gate electrode and a second (drain side) gate electrode, the gate width of the first gate electrode being narrower than that of the second gate electrode;
means for coupling an input signal to the first gate electrode;
means for coupling a local oscillator signal to the second gate; and
means for receiving an output signal of the amplifier circuit from the drain.
